# EUROPEAN PATENT SPECIFICATION

(11) **EP 1 593 760 B1**
(45) Date of publication and mention of the grant of the patent: **17.11.2010**
(21) Application number: 05009819.3
(22) Date of filing: 04.05.2005
(51) Int. Cl.: C30B 29/40, C30B 25/02

(54) **Method for preparing non-polar single crystalline A-plane nitride semiconductor wafer**
Verfahren zur Herstellung einer unpolaren einkristallinen A-Kristallebene orientierte Scheibe aus Nitrid-Halbleiter
Procédé de fabrication d'une plaquette non-polaire monocristalline orientée selon le plan A d'un semiconducteur du type nitrure

(30) Priority: 07.05.2004 KR 2004032195
(43) Date of publication of application: 09.11.2005
(73) Proprietor: Samsung Corning Precision Materials Co., Ltd., Gumi-si Gyeongsangbuk-do 730-360 (KR)
(72) Inventor: Shin, Hyun-Min, Seoul 131-206 (KR); Lee, Hae-Yong, Kwangmyeong-si, Kyungki-do 423-758 (KR); Lee, Changho, Seocho-gu Seoul 137-797 (KR); Kim, Hyun-Suk, Cheonan-si Chungcheongnam-do 330-210 (KR); Kim, Chong-Don, Seongnam-si, Kyungki-do 463-060 (KR); Kong, Sun-Hwan, Hwaseong-si, Kyungki-do 445-810 (KR)
(74) Representative: Goddar, Heinz J.

(56) References cited:
- EP-A- 1 172 464
- US-A1- 2003 127 041
- US-A1- 2003 198 837
- US-B1- 6 528 394
- MELTON W A ET AL: "GaN growth on sapphire" JOURNAL OF CRYSTAL GROWTH, NORTH-HOLLAND, AMSTERDAM, NL, vol. 178, no. 1-2, June 1997 (1997-06), pages 168-173, XP004084983 ISSN: 0022-0248

## Description

### FIELD OF THE INVENTION

The present invention relates to a non-polar single crystalline a-plane nitride semiconductor wafer having no voids, bending or cracks, and a method for preparing said nitride semiconductor wafer.

### BACKGROUND OF THE INVENTION

Single crystalline nitride-based wafers employed as substrates in manufacturing semiconductor devices are mostly c-plane ({0001}-plane) thin films which are grown on c-plane sapphire substrates by a conventional method, e.g., metal organic chemical vapor deposition (MOCVD), molecular beam epitaxy (MBE) and hydride vapor phase epitaxy (HVPE), and then separated therefrom.

Such c-plane nitride films grown on c-plane sapphire substrates, however, tend to generate cracks due to the differences in the lattice parameter and thermal expansion coefficient at the interface during a growth process. This crack problem is more serious in case of c-plane nitride films doped with elements such as silicon. Also, the c-plane nitride films, for example GaN/AlGaN heterostructures over c-plane sapphire or (0001) SiC substrates, possess spontaneous or piezoelectric polarization field along the polar c-axis of the wurtzite crystal structure. These polarization discontinuities generate at interfaces between adjacent device layers fixed sheet charges which give rise to internal electric fields. These polarization-induced electric fields spatially separate electrons and hole wavefunctions in quantum well structures, thereby reducing internal quantum efficiencies and significantly altering the electronic and optical properties of the device.

In contrast to the c-plane nitride films, a-plane ({11-20}-plane) nitride films grown on r-plane ({1-102}-plane) sapphire substrates are non-polar, thus exhibit no polarization field and quantum confined Stark effect, and can be advantageously used for high efficiency light-emitting diodes and high power microwave transistors.

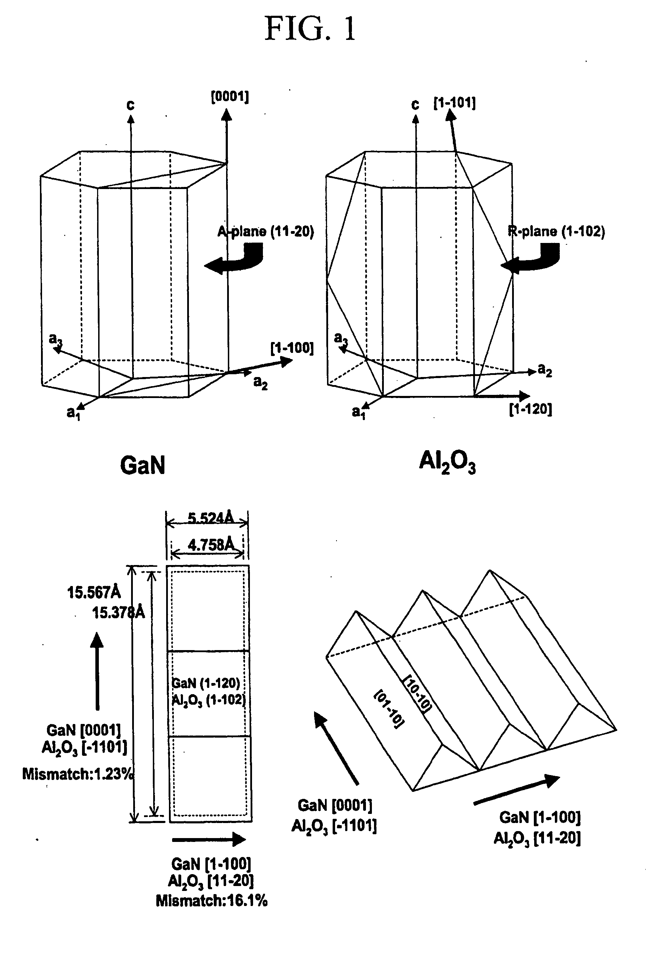

Nevertheless, such a-plane nitride film substrates are not yet commercially available for the reason that when an a-plane nitride film is grown on an r-plane substrate, it attains an uneven surface morphology with {1010}-plane ridges extended toward the <0001> direction (see FIG. 1) and internal macro-voids due to the lack of coalescence of these ridges. The above surface irregularity and the macro defects limit fabrication and performance of the multi-layer device.

US Patent Publication No. 2003-198837 describes a method of growing 1.5 *µ*m thick a-plane gallium nitride (GaN) films with planar surfaces on r-plane sapphire substrates by forming a low temperature GaN buffer layer having an 100nm-thickness prior to a high temperature growth of the a-plane GaN film at a low pressure by MOCVD. However, this method is not appropriate for the formation of a thick film of 30 *µ*m or more which is useful as a freestanding substrate.

US 2003-0127041 describes growing a GN film several hundred microns thick on a sapphire substrate by HVPE. The film is then separated to form a freestanding wafer blank.

### SUMMARY OF THE INVENTION

Accordingly, it is an object of the present invention to provide a high quality non-polar single crystalline a-plane nitride semiconductor wafer having no voids, bending or cracks.

The present invention provides an effective method as set forth in claim 1 for preparing said nitride semiconductor wafer.

In accordance with one aspect of the present invention, there is provided a single crystalline a-plane nitride semiconductor wafer having a thickness of 130 *µ*m or more obtained by conducting hydride vapor phase epitaxy (HVPE) on a single crystalline r-plane sapphire substrate.

In accordance with the present invention, there is provided a method for preparing a single crystalline a-plane nitride semiconductor wafer which comprises growing at a rate of 30 to 300 *µ*m/hr the a-plane nitride film on a single crystalline r-plane sapphire substrate heated to a temperature ranging from 950 to 1,100°C by hydride vapor phase epitaxy (HVPE), separating the grown a-plane nitride film from the substrate, and polishing the surface thereof.

### BRIEF DESCRIPTION OF THE DRAWINGS

The above and other objects and features of the present invention will become apparent from the following description of the invention, when taken in conjunction with the accompanying drawings, which respectively show:
FIG. 1 : schematic diagrams which show the differences in the lattice parameter in case of heteroepitaxial growth of a single crystalline a-plane nitride thick film on a single crystalline r-plane sapphire substrate and the ridge-like surface morphology of the grown nitride film;
FIG. 2 : the steps for preparing a single crystalline a-plane nitride wafer in accordance with one preferred embodiment of the inventive method;
FIG. 3 : micro-cracks generated inside an r-plane sapphire substrate when a single crystalline a-plane nitride thick film is grown on the sapphire substrate in accordance with the inventive method;
FIGs. 4 and 5 : a photograph and an X-ray diffraction (XRD) pattern of the a-plane GaN thick film (before polishing) obtained in Example 1, respectively;
FIG. 6 : a photograph of the a-plane GaN thick film (after separation and polishing) obtained in Example 1;
FIGs. 7A and 7B : a scanning electron microscope (SEM) photograph and an XRD rocking curve of the surface of the a-plane GaN thick film (before polishing) obtained in Example 1, respectively; and
FIGs. 8A and 8B : an SEM photograph and an XRD rocking curve of the surface of the a-plane GaN thick film (before polishing) obtained in Example 2, respectively.
11 : single crystalline r-plane sapphire substrate
12 : nitridated surface of the r-plane sapphire substrate
13 : single crystalline a-plane nitride semiconductor thin film
14 : single crystalline a-plane nitride semiconductor thick film
20 : polished freestanding a-plane nitride semiconductor wafer

### DETAILED DESCRIPTION OF THE INVENTION

The present invention is characterized in that a non-polar single crystalline a-plane nitride semiconductor wafer having no voids, bending or cracks is prepared by growing the nitride semiconductor film on an r-plane sapphire substrate at a rate of 30 to 300 *µ*m/hr and at a temperature ranging from 950 to 1,100°C by HVPE.

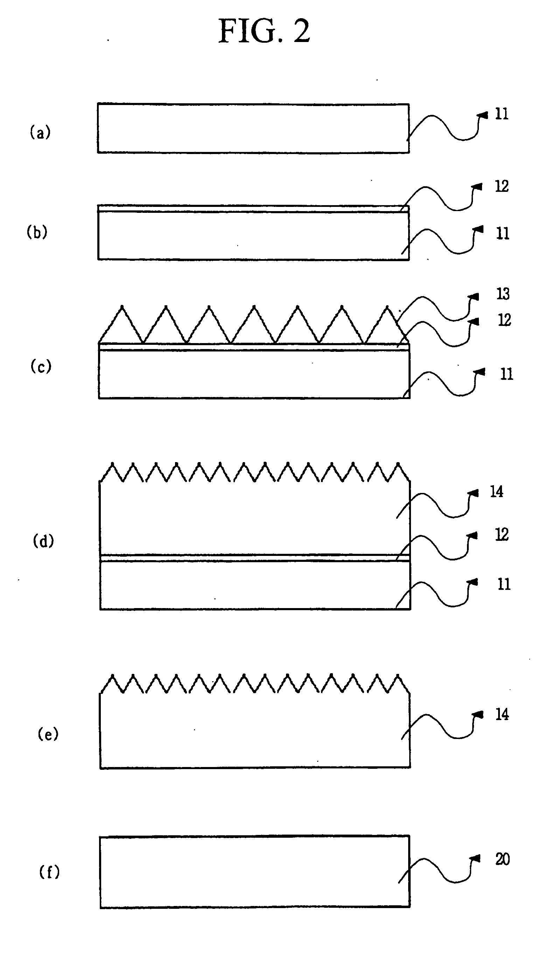

FIG. 2 illustrates the series of steps for preparing a single crystalline a-plane nitride wafer as a freestanding plate in accordance with one preferred embodiment of the inventive method, the steps comprising; (a) preparing a single crystalline r-plane sapphire substrate (11), (b) nitridating one surface of the sapphire substrate (11), (c) growing a single crystalline a-plane nitride semiconductor thin film (13) on the nitridated surface of the substrate (12) using HVPE in accordance with the inventive method, (d) continuing the growth of the nitride film (13) to form a coalesced a-plane nitride semiconductor thick film (14), (e) separating the nitride film (14) from the substrate (11), and (f) polishing a surface of the separated nitride film to form a planar a-plane nitride semiconductor freestanding plate (20).

The nitride compound semiconductor grown on the substrate may be a nitride of at least one III-group element selected from the group consisting of Ga, Al and In, which is represented by formula [AlₓGa_{y}In_{1-x-y}N] (0≤ x≤ 1, 0≤ y≤ 1, 0≤ x+y≤ 1). Besides sapphire (α -Al₂O₃), any one of conventional materials such as ZnO, Si, SiC, lithium aluminate, lithium gallite, GaAs and GaN may be employed as the r-plane substrate.

In accordance with the inventive method, the a-plane nitride semiconductor film may be grown on the r-plane sapphire substrate by hydride vapor phase epitaxy (HVPE) at a growth rate of 30 to 300 *µ*m/hr, preferably 30 to 200 *µ*m/hr, by way of bringing the vapor of a chloride of a III-group element and gaseous ammonia (NH₃) into contact with the surface of the substrate maintained at a temperature ranging from 950 to 1,100°C. When the growth temperature is lower than 950°C, the crystallinity of the nitride film becomes poor, and when higher than 1,100°C , the growth rate and crystallinity become low due to the decomposition of the grown nitride crystals. In case the growth rate is higher than 300 *µ*m/hr, the deterioration of the crystallinity of the nitride film is also observed due to insufficient time for the constituents to diffuse to an appropriate crystal lattice site.

The vapor of the chloride of the III-group element may be generated in the HVPE reactor by placing one or more III-group elements on a vessel and introducing gaseous hydrogen chloride (HCl) thereto. The reactor chamber may be maintained at a temperature ranging from 600 to 900°C under an ambient pressure. The gaseous hydrogen chloride and ammonia may be introduced at a volume ratio of 1 : 2 ~ 20, preferably of 1 : 2 ~ 5. Provided in the former case is an a-plane nitride film having an FWHM (full width at half maximum) value of 1,000 arcsec or less in an X-ray diffraction (XRD) rocking curve, and in the latter case, an a-plane nitride film having an FWHM value of 500 arcsec or less is obtained. The reduction in the FWHM value is indicative of enhanced crystallinity.

If necessary, the surface of the r-plane sapphire substrate may be nitridated by way of bringing a gas mixture of ammonia (NH₃) and hydrogen chloride (HCl) into contact therewith at a temperature ranging from 900 to 1,100°C. In addition, for the purpose of enhancing the nitridation, the surface of the substrate may be further treated with gaseous ammonia (NH₃) before or after the above nitridation step. Such nitridation of the substrate surface may be performed in an HVPE reactor. The nitridation technique using an ammonia (NH₃) - hydrogen chloride (HCl) gas mixture is disclosed in US Patent No. 6,528,394 which is incorporated by reference in the present invention.

The a-plane nitride film growth on the r-plane substrate by HVPE at a growth temperature ranging from 950 to 1,100°C and a growth rate ranging from 30 to 300 *µ*m/hr allows the <0001> directional ridges present in the nitride film surface to coalesce with each other, resulting in the formation of the desired a-plane nitride thick film having no voids.

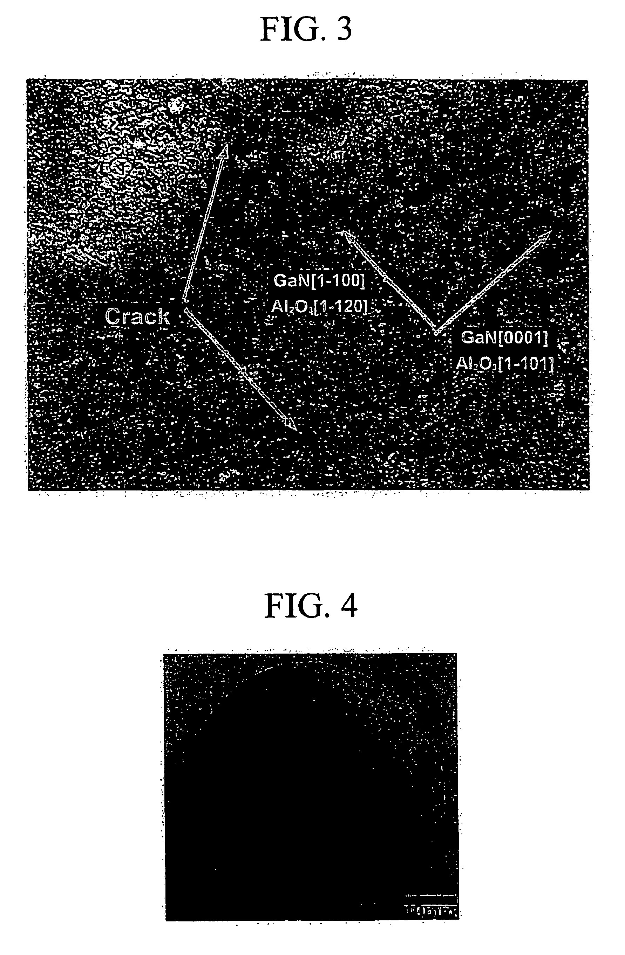

Further, such an a-plane nitride film growth leads to the formation of micro-cracks inside the underlying substrate due to large anisotropy of the internal stress as shown in FIG 3. The micro-cracks formed inside the substrate do not interconnect but act to reduce the internal stress generated in the nitride film, thereby giving no adverse effects on the shape of the substrate or the nitride film formed thereon.

Thus, in the inventive method, the a-plane nitride thick film having a thickness of 130 *µ*m or more, preferably of 150 *µ*m or more, more preferably of 300 *µ*m or more, and a diameter of 25mm, preferably of 50.8mm(2 inch) can be grown without any voids, bending and cracks. In particular, the nitride film may be grown to an unlimited thickness.

Then, the grown a-plane nitride film may be separated from the substrate and the surface of the separated nitride film may be polished by conventional methods to obtain an improved a-plane nitride wafer with smooth surfaces.

As described above, the present invention provides for the first time a high quality non-polar single crystalline a-plane nitride semiconductor wafer having no voids, bending or cracks that can be used as a freestanding plate for the manufacture of a light-emitting diode (LED).

The following Examples are given for the purpose of illustration only, and are not intended to limit the scope of the invention.

### <Example 1 >

A single crystalline r-plane sapphire substrate with a 50.8mm-diameter was loaded in an HVPE reactor, and nitridated at 950 ~ 1,100°C successively with gaseous ammonia, a gas mixture of ammonia and hydrogen chloride, and gaseous ammonia.

On the nitridated substrate thus obtained, a gallium nitride single crystal film was allowed to grow at a rate of 75 *µ*m/hr by bringing gaseous gallium chloride and gaseous ammonia into contact therewith at 1,000°C. The gallium chloride gas, generated by reacting gallium with hydrogen chloride, and the gaseous ammonia were introduced through two separate inlets at a gaseous hydrogen chloride : ammonia volume ratio of 1 : 6. The reactor chamber was maintained at a temperature ranging from 600 to 900°C under an ambient pressure. The growth of gallium nitride single crystal film was conducted for 400 minutes to form a 500 *µ*m-thick gallium nitride semiconductor film on the substrate.

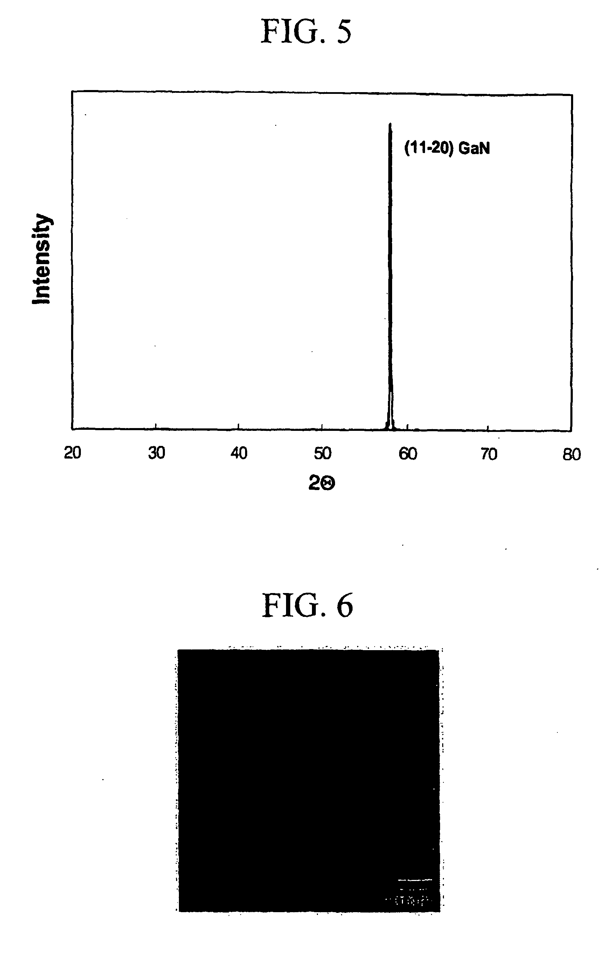

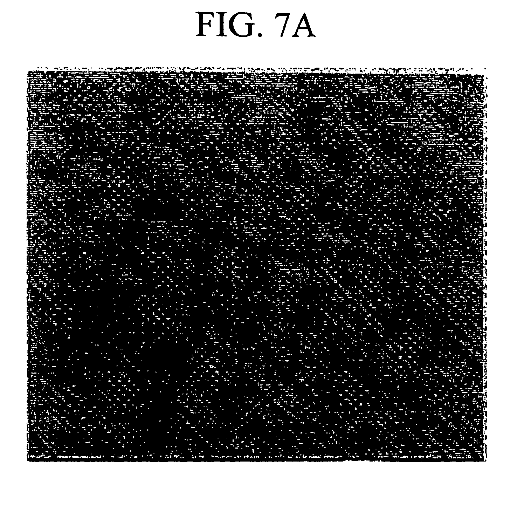

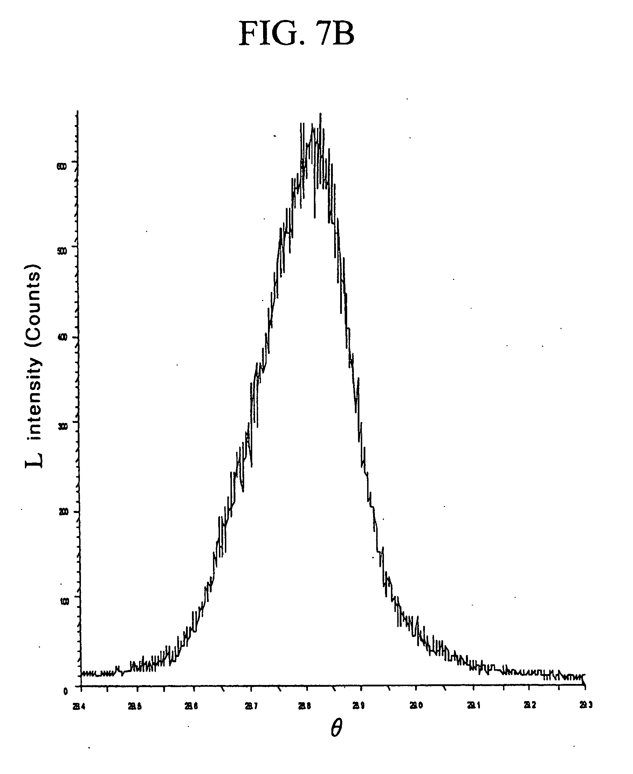

A photograph and an X-ray diffraction (XRD) pattern of the a-plane GaN thick film thus formed are shown in FIGs. 4 and 5, respectively. A scanning electron microscope (SEM) photograph and an XRD rocking curve of the surface thereof are shown in FIGs. 7A and 7B, respectively. The XRD rocking curve of FIG. 7B suggests that the a-plane nitride film with an FWHM (full width at half maximum) value of 871 arcsec was obtained.

Then, the grown a-plane nitride film was separated from the substrate using a 355nm Q-switched Nd:YAG excimer laser. The surface of the separated nitride film was polished using a wafer lapping and polishing machine to obtain a 400 *µ*m-thick gallium nitride freestanding plate.

A photograph of the resultant a-plane GaN plate is shown in FIG. 6, which confirms it is a smooth plate with no surface defects.

### <Example 2>

The procedure of Example 1 was repeated except that the volume ratio of the gaseous hydrogen chloride and ammonia was in the range of 1 : 2 ~ 5, to form a 500 *µ*m-thick gallium nitride semiconductor film on the sapphire substrate.

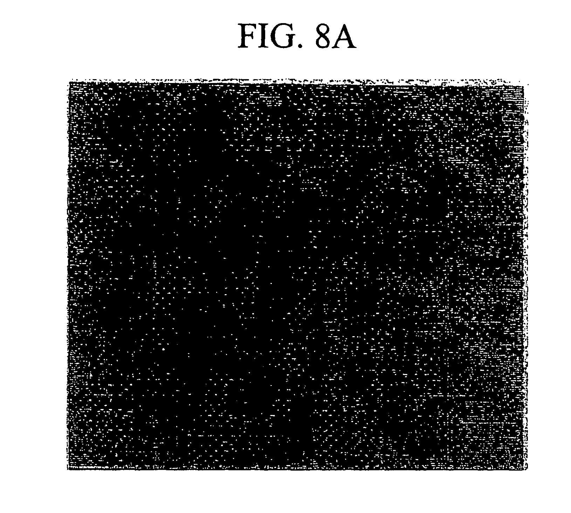

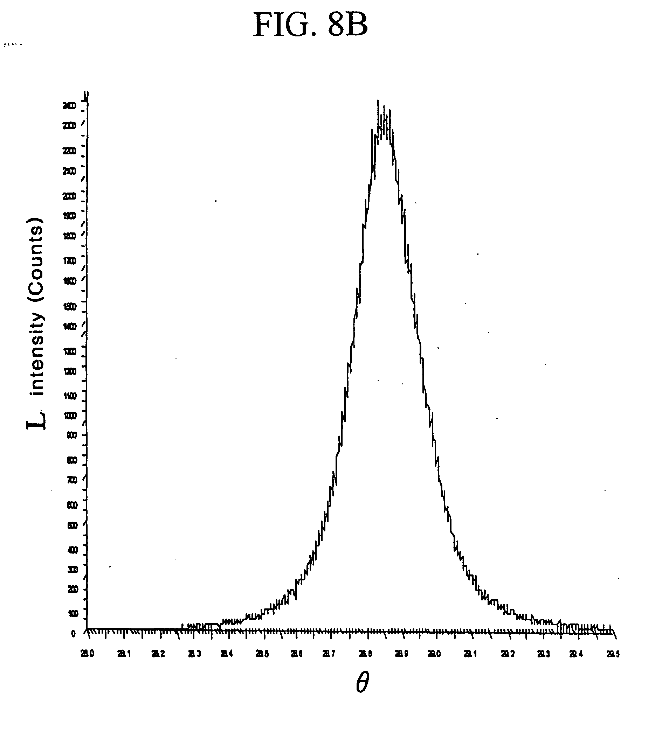

An SEM photograph and an XRD rocking curve of the surface of the a-plane GaN thick film thus formed are shown in FIGs. 8A and 8B, respectively. The XRD rocking curve of FIG. 8B reveals that the a-plane nitride film possesses an FWHM value of 342 arcsec, the smallest among the hitherto-reported values, which indicates that the film crystallinity was significantly enhanced.

As described above, in accordance with the method of the present invention, a high quality non-polar single crystalline a-plane nitride semiconductor wafer having no voids, bending or cracks may be rapidly and effectively prepared and it may be advantageously used as a substrate in the manufacture of an LED.

While the invention has been described with respect to the above specific embodiments, it should be recognized that various modifications and changes may be made to the invention by those skilled in the art which also fall within the scope of the invention as defined by the appended claims.

## Claims

1. A method for preparing a single crystalline a-plane ({11-20}-plane) nitride semiconductor wafer which comprises growing at a rate of 30 to 300 µm/hr the a-plane nitride film on a single crystalline r-plane sapphire substrate heated to a temperature ranging from 950 to 1.100°C by hydride vapour phase epitaxy (HVPE), separating the grown a-plane nitride from the substrate, and polishing the surface thereof.

2. The method of claim 1, wherein the growth of the a-plane nitride film is conducted by bringing the vapour of a chloride of a III-group element and gaseous ammonia (NH₃) into contact with the surface of the substrate in a reactor chamber, the vapour of the chloride of the III-group element being generated through a reaction between the III-group element and gaseous hydrogen chloride.

3. The method of claim 2, wherein the volume ratio of the gaseous hydrogen chloride and ammonia is in the range of 1:2~20.

4. The method of claim 2, wherein the volume ratio of the gaseous hydrogen chloride and ammonia is in the range of 1:2~5.

5. The method of claim 1, wherein the surface of the r-plane sapphire substrate for the growth is nitridated by treating with a gas mixture of ammonia (NH₃) and hydrogen chloride (HCl).

6. The method of claim 1, wherein the growth of the a-plane nitride film continues until a desired thickness thereof is achieved.

## Patentansprüche

1. Verfahren zur Herstellung eines einkristallinen Nitridhalbleiterwafers mit a-Ebene ({11-20}-Ebene), das ein Wachsen mit einer Geschwindigkeit von 30 bis 300 µm/Stunde des Nitridfilms mit a-Ebene auf einem einkristallinen Saphirsubstrat mit r-Ebene, erwärmt auf eine Temperatur im Bereich von 950 bis 1.100°C, durch Hydriddampfphasenepitaxie (HVPE), Trennen des gewachsenen Nitrids mit a-Ebene von dem Substrat und Polieren der Oberfläche desselben umfasst.

2. Verfahren nach Anspruch 1, wobei das Wachstum des Nitridfilms mit a-Ebene durchgeführt wird durch Inkontaktbringen des Dampfes eines Chlorids eines Elements der Gruppe III und gasförmigen Ammoniaks (NH₃) mit der Oberfläche des Substrats in einer Reaktionskammer, wobei der Dampf des Chlorids des Elements der Gruppe III durch eine Reaktion zwischen dem Element der Gruppe III und gasförmigem Chlorwasserstoff erzeugt wird.

3. Verfahren nach Anspruch 2, wobei das Volumenverhältnis des gasförmigen Chlorwasserstoffs und des Ammoniaks im Bereich von 1:2~20 liegt.

4. Verfahren nach Anspruch 2, wobei das Volumenverhältnis des gasförmigen Chlorwasserstoffs und des Ammoniaks im Bereich von 1:2~5 liegt.

5. Verfahren nach Anspruch 1, wobei die Oberfläche des Saphirsubstrats mit r-Ebene für das Wachstum nitridiert wird durch Behandlung mit einer Gasmischung aus Ammoniak (NH₃) und Chlorwasserstoff (HCl).

6. Verfahren nach Anspruch 1, wobei das Wachstum des Nitridfilms mit a-Ebene fortfährt, bis eine gewünschte Dicke desselben erreicht ist.

## Revendications

1. Procédé de préparation d'une plaquette semiconductrice monocristalline dans le plan a ({11-20} qui consiste en la croissance à une vitesse de 30 à 300 µm/heure du film de nitrure dans le plan a sur un substrat de saphir monocristallin dans le plan r chauffé jusqu'à une température comprise entre 950 et 1 100°C par épitaxy hybride en phase vapeur (HVPE), en séparant la croissance de nitrure dans le plan a de la substance et en polissant sa surface.

2. Procédé de la revendication 1, dans lequel la croissance du film de nitrure dans le plan a est réalisée amenant la vapeur d'un chlorure d'un élément de groupe III et d'un ammoniac gazeux (NH₃) en contact avec la surface du substrat dans une chambre de réaction, la vapeur du chlorure de l'élément de groupe III étant générée par le biais d'une réaction entre l'élément de groupe III et le chlorure d'hydrogène gazeux.

3. Procédé de la revendication 2, dans lequel le rapport en volume du chlorure d'hydrogène gazeux et de l'ammoniac est compris entre environ 1:2 et 20.

4. Procédé de la revendication 2, dans lequel le rapport en volume du chlorure d'hydrogène gazeux et de l'ammoniac est compris entre environ 1:2 et 5.

5. Procédé de la revendication 1, dans lequel la surface du substrat de saphir dans le plan r pour la croissance est nitrure par un traitement avec un mélange gazeux d'ammoniac (NH₃) et de chlorure d'hydrogène (HCl).

6. Procédé selon la revendication 1, dans lequel la croissance du film de nitrure dans le plan a se poursuit jusqu'à l'obtention de l'épaisseur de film souhaitée.
